# EUROPEAN PATENT APPLICATION

(11) **EP 4 567 871 A1**
(43) Date of publication of application: **11.06.2025**
(21) Application number: 24179600.2
(22) Date of filing: 03.06.2024
(51) Int. Cl.: H01L 21/67, H01L 21/677, H01L 21/687

(54) **APPARATUS AND METHOD FOR PROCESSING A SEMICONDUCTOR SUBSTRATE**

(30) Priority: 08.12.2023 GB 202318810
(71) Applicant: SPTS Technologies Limited, Newport Gwent NP18 2TA (GB)
(72) Inventor: Waller, Phil, Newport (GB); Collin, Mike, Newport (GB); Walbeoff, Rhys Lewis, Newport (GB)
(74) Representative: Wynne-Jones IP Limited

(57) **Abstract**

According to the invention there is provided apparatus for processing a semiconductor substrate comprising:
one or more semiconductor substrate handling devices through which a semiconductor substrate can be introduced to and/or removed from the apparatus;
a plurality of process chambers for processing the semiconductor substrate; and
a transport module for transporting the semiconductor substrate under vacuum conditions between the semiconductor substrate handling devices and the plurality of process chambers;
in which the transport module comprises:
a vacuum chamber comprising a main chamber and a degas sub-chamber;
a first pumping system in connection with the main chamber for maintaining a vacuum within the main chamber;
a second pumping system in connection with the degas sub-chamber for maintaining a vacuum within the degas sub-chamber;
at least one transport device for transporting the semiconductor substrate between desired locations which include the semiconductor substrate handling devices and the plurality of process chambers;
a substrate support; and
a lifting device for moving the substrate support between a raised position and a lowered position; the lifting device being configured so that the lowered position allows the transport device to position a semiconductor substrate on the substrate support and the raised position causes (i) a semiconductor substrate disposed on the substrate support to be positioned within the degas sub-chamber and (ii) the degas sub-chamber to be sealed from the main chamber so that a vacuum is maintained in the degas sub-chamber by the second pumping system.

## Description

### Field of the Disclosure

This invention relates to an apparatus for processing a semiconductor substrate, with particular reference to an apparatus that provides a degassing functionality. The invention relates also to an associated transport module for transporting a semiconductor substrate under vacuum conditions, and to an associated method of processing a semiconductor substrate.

### Background of the Disclosure

It is well known to deposit thin films of materials such as metals or dielectric materials onto semiconductor wafer surfaces using techniques such as physical vapour deposition (PVD), chemical vapour deposition (CVD), plasma enhanced chemical vapour deposition (PECVD), or by atomic layer deposition (ALD). It is essential that the semiconductor wafer surfaces are suitably prepared prior to depositing a layer by any of these deposition methods. Each of these deposition methods occurs at reduced pressure to maintain film quality by minimising the presence of unwanted contaminants. To maximise productivity, these deposition steps are invariably carried out in cluster tools where a large number of process modules are located around a central transport module (TM). Frequently, a degas or pre-heat step, and potentially an etch step or a combination of steps, are required prior to the thin film deposition step. This is to ensure that contaminants from the surface of the wafer such as water and organic compounds are removed and the wafer is at the correct temperature for the deposition process.

The productivity or throughout of a system (typically measured in wafers/hr) is a significant factor in determining the performance of a manufacturing system. Therefore, it is important that the wafer processing sequence is well balanced to maximise the throughput. As the number of process steps increases, resulting in the use of different process modules, it becomes increasingly challenging to avoid bottlenecks in the integrated process flow. This can result in idle time during a process. The sequencing of wafers in cluster tools is frequently dictated by the availability of a process module to carry out the next process step. In many applications, the pressures in the process module and the transport module will have to be below a defined set point before the slot valve between the module and the transport module can be opened. This is to avoid cross contamination between stations.

Degassing or pre-heating wafers in a cluster tool typically involves uniformly heating a wafer to a required temperature and removing the desorbed gases from the region where the wafer is heated, so that desorbed gases are not adsorbed back onto the wafer and do not degrade the vacuum performance of the TM or the process modules. Degassing is typically performed in a process module or in a lock/ load system which forms part of a wafer handling device which is used to introduce wafers into the TM. As the temperature of the wafer increases, the pressure in the region of the wafer increases until the majority of the contaminants have been removed. Particular problems are encountered in PVD systems which use organic passivation layers such as polyimide (PI) and polybenzoxazole (BPO) for wafer packing and as mould layers for Fan-out wafer-level packaging (FOWLP) applications. The demands made on the degassing capacity of these systems is increased due to the temperature sensitivity of the organic passivation layers and the amount of contaminants present in these layers.

### Statement of Invention

The present invention, in at least some of its embodiments, addresses the above-described problems, desires and requirements. In particular, the present invention, in at least some of its embodiments, addresses the problem of improving the productivity of an integrated cluster tool which is limited by its degassing capacity. It will be appreciated that whilst the invention finds particular utility in the degassing of substrates that comprise organic passivation layers such as PI and BPO, the invention is not limited in this respect. Rather, the present invention is widely applicable to a range of substrates, process modules and cluster tools.

According to a first aspect of the invention there is provided an apparatus for processing a semiconductor substrate comprising:
one or more semiconductor substrate handling devices through which a semiconductor substrate can be introduced to and/or removed from the apparatus;
a plurality of process chambers for processing the semiconductor substrate; and
a transport module for transporting the semiconductor substrate under vacuum conditions between the semiconductor substrate handling devices and the plurality of process chambers;
in which the transport module comprises:
   a vacuum chamber comprising a main chamber and a degas sub-chamber;
   a first pumping system in connection with the main chamber for maintaining a vacuum within the main chamber;
   a second pumping system in connection with the degas sub-chamber for maintaining a vacuum within the degas sub-chamber;
   at least one transport device for transporting the semiconductor substrate between desired locations which include the semiconductor substrate handling devices and the plurality of process chambers;
   a substrate support; and
   a lifting device for moving the substrate support between a raised position and a lowered position; the lifting device being configured so that the lowered position allows the transport device to position a semiconductor substrate on the substrate support and the raised position causes (i) a semiconductor substrate disposed on the substrate support to be positioned within the degas sub-chamber and (ii) the degas sub-chamber to be sealed from the main chamber so that a vacuum is maintained in the degas sub-chamber by the second pumping system.

Apparatus of this kind offer numerous advantages. In comparison with prior art apparatus in which a degas chamber is provided at a process chamber position, an extra process chamber position is made available. This can either enhance the throughput of the apparatus or provide additional tool flexibility. In comparison with prior art apparatus in which an in-line degas station is provided in a load lock device, the present invention enables the load lock module to act solely as a load lock. This reduces atmosphere to vacuum (and vacuum to atmosphere) transfer times. Also, the degassing takes place in an environment which is not vented to atmosphere and which has a dedicated pumping system. Alternatively, the apparatus of the invention could be provided with one or more in-line load lock devices which have a degas station. This provides a further increase in the degassing capacity of the apparatus. The degas sub-chamber can be pumped continuously and thus be evacuated before opening the sub-chamber to the transport module by lowering the substrate support. The degas sub-chamber can be readily vacuum isolated from the transport module to carry out general maintenance. Contamination of the transport module and the first pumping system can be avoided by the vacuum isolation of the degas sub-chamber from the transport module and through the provision of dedicated pumping of the degas sub-chamber with the second pumping system.

The vacuum chamber can further comprise an auxiliary sub-chamber disposed between the main chamber and the degas sub-chamber wherein, in its lowered position, the substrate support is disposed within the auxiliary sub-chamber to allow the transport device to position the semiconductor substrate on the substrate support. The degas sub-chamber can be disposed above the auxiliary sub-chamber.

The auxiliary sub-chamber can be in vacuum communication with the main chamber. The vacuum communication can be through an opening formed in the main chamber.

The degas sub-chamber can be disposed in a peripheral region of the main chamber between two semiconductor substrate handling devices.

The semiconductor substrate handling devices and the plurality of process chambers can be each in vacuum communication with the main chamber of the transport module through respective openable and closeable gates. The gates can be slot valves. The degas sub-chamber can be positioned above the slot valves.

The semiconductor substrate handling devices and the plurality of process chambers can be disposed circumferentially around the main chamber.

The degas sub-chamber can comprise one or more heating devices for increasing the temperature of the semiconductor substrate. The one or more heating devices can be disposed above the lifting device.

The one or more heating devices can comprise at least one device for emitting electromagnetic radiation. Optionally, the at least one device for emitting electromagnetic radiation is at least one IR emitting device.

The degas sub-chamber can be sealed from the main chamber in the raised position of the substrate support through contact of the substrate support with a sealing surface. The sealing surface can be an O ring. The sealing surface can be disposed on a lower face of the degas sub-chamber. Other suitable sealing systems would readily suggest themselves to the skilled reader.

The transport device typically transports the semiconductor substrate between different positions on a common handling plane. The raised position of the lifting device can position the semiconductor substrate on a plane which is above the handling plane.

The first pumping system can comprise a turbomolecular pump. The second pumping system can comprise a cryogenic pump. Other kinds of high vacuum and ultra high vacuum pumps can be contemplated for use in the first and/or second pumping systems. Each of the first and second pumping systems can comprise a roughing pump, typically a mechanical pump.

The one or more semiconductor substrate handling devices can comprise vacuum chamber elevators (VCEs). Alternatively, the one or more semiconductor substrate handling devices can comprise load lock modules. The one or more semiconductor substrate handling devices can comprise an EFEM (Equipment Front End Module).

The at least one transport device of the transport module can comprise a robot transport device. The robot transport device can comprise one or more robotic arms.

The process chambers can be of any desired type, such as PVD, etch or CVD, PECVD chambers. The process chambers can in principle comprise additional degas/pre-heat chambers.

According to a second aspect of the invention there is provided a transport module for transporting a semiconductor substrate under vacuum conditions comprising:
a vacuum chamber comprising a main chamber and a degas sub-chamber;
a first pumping system in connection with the main chamber for maintaining a vacuum within the main chamber;
a second pumping system in connection with the degas sub-chamber for maintaining a vacuum within the degas sub-chamber;
at least one transport device for transporting a semiconductor substrate between desired locations;
a substrate support; and
a lifting device for moving the substrate support between a raised position and a lowered position; the lifting device being configured so that the lowered position allows the transport device to position a semiconductor substrate on the substrate support and the raised position causes (i) a substrate disposed on the substrate support to be positioned within the degas sub-chamber and (ii) the degas sub-chamber to be sealed from the main chamber so that a vacuum is maintained in the degas sub-chamber by the second pumping system.

According to a third aspect of the invention there is provided a degas apparatus for retro-fitting to an existing transport module to provide a transport module according to the third aspect of the invention, the degas apparatus comprising:
a degas sub-chamber;
a pumping system in connection with the degas sub-chamber for maintaining a vacuum within the degas sub-chamber;
an auxiliary sub-chamber having an opening, the degas sub-chamber being disposed above the auxiliary sub-chamber;
a substrate support; and
a lifting device for moving the substrate support between a raised position and a lowered position; the lifting device being configured so that the lowered position allows the a semiconductor substrate to be introduced to the auxiliary sub-chamber through the opening and positioned on the substrate support and the raised position causes (i) a semiconductor substrate disposed on the substrate support to be positioned within the degas sub-chamber and (ii) the degas sub-chamber to be sealed from the main chamber so that a vacuum is maintained in the degas sub-chamber by the pumping system.

According to a fourth aspect of the invention there is provided a method of processing a semiconductor substrate comprising the steps of:
providing an apparatus comprising: one or more semiconductor substrate handling devices through which a semiconductor substrate can be introduced to and/or removed from the apparatus; a plurality of process chambers for processing the semiconductor substrate; and a transport module for transporting the semiconductor substrate under vacuum conditions between the semiconductor substrate handling devices and the plurality of process chambers; in which the transport module comprises: a vacuum chamber comprising a main chamber and a degas sub-chamber; a first pumping system in connection with the main chamber to maintain a vacuum within the main chamber; a second pumping system in connection with the degas sub-chamber to maintain a vacuum within the degas sub-chamber; at least one transport device for transporting the semiconductor substrate between desired locations which include the semiconductor substrate handling devices and the plurality of process chambers; a substrate support; and a lifting device for moving the substrate support between a raised position and a lowered position;
introducing a semiconductor substrate to the main chamber of the transport module using the transport device;
using the transport device to position the semiconductor substrate on the substrate support in its lowered position;
raising the substrate support to its raised position to cause (i) the semiconductor substrate to be positioned within the degas sub-chamber and (ii) the degas sub-chamber to be sealed from the main chamber so that a vacuum is maintained in the degas sub-chamber by the second pumping system;
degassing the semiconductor substrate in the degas sub-chamber;
lowering the substrate support to its lowered position and using the transport device to position the semiconductor substrate in one of the process chambers;
processing the semiconductor substrate in one or more of the process chambers; and
transporting the semiconductor substrate to a semiconductor substrate handling device.

The semiconductor substrate can be a silicon substrate, such as a silicon wafer, or a wafer of another semiconductor material.

For the avoidance of doubt, whenever reference is made herein to 'comprising' or 'including' and like terms, the invention is also understood to include more limiting terms such as 'consisting' and 'consisting essentially'.

Whilst the invention has been described above, it extends to any inventive combination of the features set out above, or in the following description, drawings or claims. For the avoidance of doubt, the apparatus of the first, second and third aspects of the invention are intended to be able to perform the method of the fourth aspect of the invention. Therefore, any features disclosed in relation to the first, second and third aspects of the invention may be combined with any features disclosed in relation to the fourth aspect of the invention and *vice versa* as appropriate.

### Description of the Drawings

Embodiments of the invention will now be described, by way of example only, with reference to the accompanying drawings, in which:
Figure 1 is a perspective view of a portion of a transport module comprising a degas sub-chamber in (a) its open position and (b) its closed position;
Figure 2 is a semi-schematic cross-sectional plan view of an apparatus for processing a semiconductor substrate; and
Figure 3 is a process flow diagram showing a process sequence for degassing a semiconductor substrate.

### Detailed Description of the Disclosure

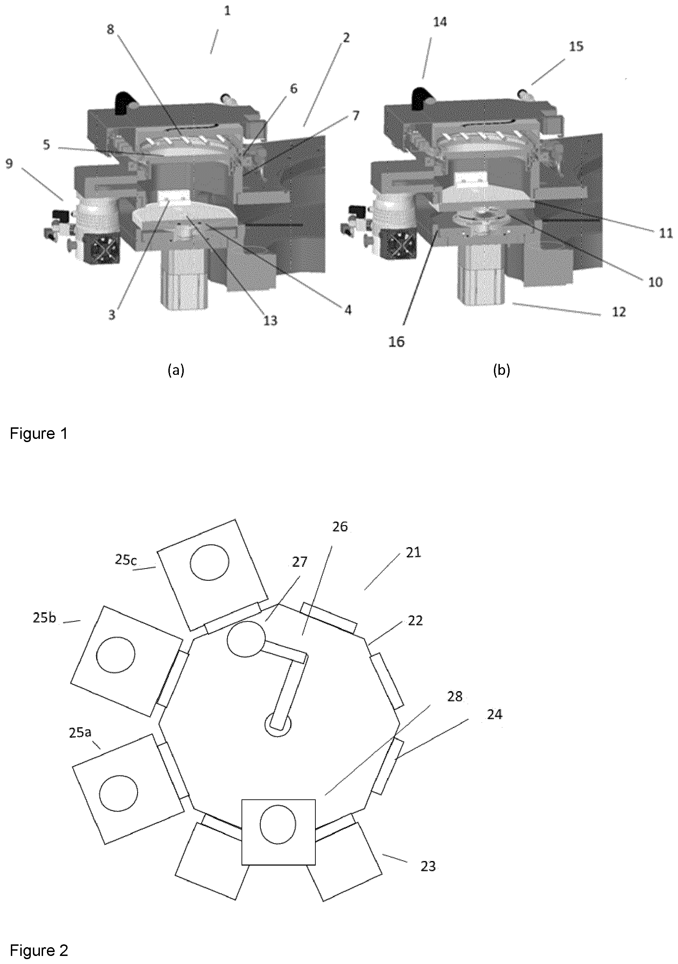

Figure 1 shows a portion of a transport module of the invention comprising a degas sub-chamber 1 and a main chamber 2 of the transport module. Figure 1(a) shows an open position of the degas sub-chamber 1 in which there is vacuum communication between the degas sub-chamber 1 and the main chamber 2 via an auxiliary sub-chamber 16. The open position of Figure 1(a) is achieved by lowering a substrate support 4. This enables an end effector of a robot device (not shown) of the transport module to place or remove a wafer on or from a ceramic retaining fixture 3 on top of the substrate support 4. Typically, the substrate to be processed is a semiconductor wafer and the substrate support is a suitable wafer support, such as a platen as shown in Figure 1. The degas sub-chamber 1 comprises a wall structure 7 formed from a suitable metal and a top window 5. The window 5 is above the wafer when the wafer is in position on the platen 4. An "O" ring seal 6 is used to seal the window 5 against an upper surface of the wall structure 7. In atmosphere above the window is an array of Infra-red (IR) lamps 8 which is used to achieve the necessary degas conditions in the chamber. The degas sub-chamber 1 is pumped by a dedicated turbo molecular pump 9 which is backed by mechanical pumps (not shown). A stainless steel bellows assembly 10 below the platen 4 is used to maintain vacuum integrity in the auxiliary sub-chamber.

Figure 1(b) shows a closed position of the degas sub-chamber 1 in which there is no vacuum communication between the degas sub-chamber 1 and the main chamber 2 / auxiliary sub-chamber 16. The closed position of Figure 1(b) is achieved by raising the substrate support 4 so that the substrate support makes a sealing contact with an "O" ring seal 11. The "O" ring seal 11 is disposed in a lower, downwardly facing surface of the wall structure 7. An actuator 12, either using compressed air or a motor, enables the substrate support 4 to the controllably raised and lowered when required. Pressure is monitored by a dedicated pressure gauge (not shown). An optional optical temperature monitoring device 13 can be located in the substrate support 4. Power and gases to the sub-chamber components are delivered through connections 14, 15.

In this way, a sealable single wafer sub-chamber is provided which can degas the wafer within the transport module structure. The wafer can be loaded into the sub-chamber under high vacuum, sealed and pumped by a more robust turbo molecular pump. The main chamber 2 of the transport module is provided with its own pumping system (not shown), which can be regarded as a first pumping system of the transport module. The turbo molecular pump 9 and associated mechanical roughing pumps can be regarded as a second pumping system of the transport module. It is common for the first pumping system to comprise a cryopump, especially if the apparatus comprises a PVD chamber. By sealing the degas sub-chamber and then maintaining a vacuum in it using the second pumping system, the first pumping system is protected from exposure to contaminates produced during the degassing process. If a cryopump were used to pump the degas sub-chamber during degas, then the cryopump would quickly fill up with moisture and the cryo-heads would quickly become contaminated. This would result in increased maintenance time because of the more frequent regeneration of the cryopump. When the TM cryopump is being regenerated the whole system inoperable and therefore not processing wafers, which of course is undesirable. In the open position of the degas sub-chamber, the extent to which the first and second pumping systems are each responsible for maintaining vacuum conditions in the auxiliary sub-chamber will likely vary between specific implementations of the invention. However, this is not a critical aspect of the invention. Indeed, it is not considered strictly necessary that the second pumping system pumps the degas sub-chamber when it is in its open position, since the first pumping system might be used to maintain vacuum conditions in the auxiliary and degas sub-chambers during this phase of operation.

In a representative example, the degas sub-chamber is designed to heat wafers to a temperature of about 500°C in about 60 seconds using the IR lamps 8. This can be achieved through the use of 4-6 1-1.25kW high colour temperature IR emitters (2900K). Other configurations and design specifications for providing an appropriate degas regime would readily suggest themselves to the skilled reader.

Figure 2 shows an apparatus of the invention, shown generally at 21, in the form of an eight sided cluster tool. The apparatus comprises a transport module 22 which incorporates a degas sub-chamber 28. The degas sub-chamber 28 is located between two vacuum chamber elevators (VCEs) 23. The cluster tool 21 further comprises three process chambers 25a, 25b, 25c which are each vacuum isolated from the transport module 22 by a slot valve 24. Each VCE 23 is isolated from the transport module 22 by a slot valve 24. A vacuum robot 26 is used to transport wafers 27 within the transport module 22 and into the process chambers 25a, 25b, 25c, the degas sub-chamber 29 and the VCEs 23. The process chambers could be of any desired type, such as PVD, etch or CVD/PECVD, or one or more degas/pre-heat modules which are additional to the degas sub-chamber 28. An alternative configuration could use a EFEM and load lock modules as opposed to VCEs. The cluster tool 21 further comprises a controller (not shown) which controls the operation of the apparatus to perform a desired process sequence.

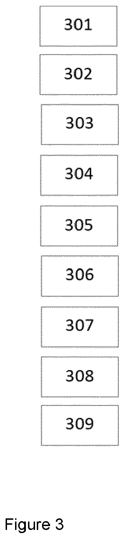

An exemplar process sequence is presented in Figure 3. The process sequence commences from a position where the degas sub-chamber is empty, under vacuum and ready to process a wafer. At step 301 the system controller signals the actuator to lower the wafer support.

At step 302 the vacuum robot loads the wafer onto the retaining fixture on the wafer support. The fixture is a ceramic ledge dimensioned to safely retain the wafer and minimise heat loss to the wafer support. The wafer support is raised at 303 until the degas chamber is vacuum isolated from the transport module. The IR lamps are switched on at 304 at a specified power for a defined duration to meet the degas requirement of the particular application. This could range from -100-500 °C for 30 seconds to several minutes duration. At the end of this period, the lamps are switched off (step 306) and the pressure gauge is monitored at 307 until the required pressure is achieved (typically ~ 10⁻⁵ Torr). At this point the wafer support is lowered (step 308). The robot removes the wafer from the chamber at 309 and transfers it to the next station. Typically, the wafer support is then raised so that the degas sub-chamber is sealed while there is no wafer present in it.

Degas is considered a `dirty' process in which deposition of contaminates occurs in the vacuum chamber. It is advantageous to provide the degas sub-chamber with removable shielding and a quartz window assembly which can be rotated to bring clean parts into operational use. In this way, maintenance times can be reduced. Shielding is typically fabricated from aluminium or stainless steel and is located in close proximity to the internal walls of the degas sub-chamber. The shielding is typically cylindrical. Since the degas sub-chamber can be isolated from the TM vacuum system, maintenance operations can avoid degrading the vacuum maintained in the TM. This is not the case for in-line degas chambers which are directly pumped through the TM.

The invention can provide substantially improved system throughput. The realisation of these benefits can be illustrated by reference to the apparatus shown in Figure 2, which has eight peripheral slot valves. Since two positions are taken up by wafer handling devices, this leaves six process module positions available on the apparatus. There are numerous sequential processes which require a degas step followed by a sputter etch and the deposition of four metal layers. An example of such a sequential process is a thick Si IGBT backside metal application with Al, Ti, NiV and Ag deposition. With prior art cluster tools that have a degas station at one of the process module positions, there is only space for one of each of the four metal deposition modules. Deposition of NiV by PVD tends to be the rate limiting step as the required deposition thickness can be five times that of the other layers and it has a relatively low deposition rate due to the magnetic properties of the material. For a 2kA Al, 1k Ti, 10kA NiV and 2k Ag stack, the throughput can be doubled using an apparatus of the invention in which the degas facility is provided in the transport module, as it enables the provision of a second NiV PVD module on the transport module. This significantly improves the cost of ownership for this application.

The invention can be implemented in a wide range of cluster tools, incorporating essentially any desired combination of process chambers. Transport chambers in accordance with the invention can manufactured from new. Alternatively, a further advantage of the invention is that it is readily possible to retrofit existing transport modules by attaching a degas sub-chamber and, optionally, an auxiliary sub-chamber to the transport module. When retrofitting, a peripheral slot formed an existing transport chamber is a convenient conduit into a sub-chamber arrangement which can be attached to the main transport module structure.

## Claims

1. An apparatus for processing a semiconductor substrate comprising:
one or more semiconductor substrate handling devices through which a semiconductor substrate can be introduced to and/or removed from the apparatus;
a plurality of process chambers for processing the semiconductor substrate; and
a transport module for transporting the semiconductor substrate under vacuum conditions between the semiconductor substrate handling devices and the plurality of process chambers;
in which the transport module comprises:
a vacuum chamber comprising a main chamber and a degas sub-chamber;
a first pumping system in connection with the main chamber for maintaining a vacuum within the main chamber;
a second pumping system in connection with the degas sub-chamber for maintaining a vacuum within the degas sub-chamber;
at least one transport device for transporting the semiconductor substrate between desired locations which include the semiconductor substrate handling devices and the plurality of process chambers;
a substrate support; and
a lifting device for moving the substrate support between a raised position and a lowered position; the lifting device being configured so that the lowered position allows the transport device to position a semiconductor substrate on the substrate support and the raised position causes (i) a semiconductor substrate disposed on the substrate support to be positioned within the degas sub-chamber and (ii) the degas sub-chamber to be sealed from the main chamber so that a vacuum is maintained in the degas sub-chamber by the second pumping system.

2. An apparatus according to claim 1 in which the vacuum chamber further comprises an auxiliary sub-chamber disposed between the main chamber and the degas sub-chamber wherein, in its lowered position, the substrate support is disposed within the auxiliary sub-chamber to allow the transport device to position the semiconductor substrate on the substrate support.

3. An apparatus according to claim 1 in which the degas sub-chamber is disposed above the auxiliary sub-chamber.

4. An apparatus according to claim 2 or claim 3 in which the auxiliary sub-chamber is in vacuum communication with the main chamber through an opening formed in the main chamber.

5. An apparatus according to any one of claims 1 to 4 in which the degas sub-chamber is disposed in a peripheral region of the main chamber between two semiconductor substrate handling devices.

6. An apparatus according to any one of claims 1 to 5 in which the semiconductor substrate handling devices and the plurality of process chambers are each in vacuum communication with the main chamber of the transport module through respective openable and closeable gates.

7. An apparatus according to claim 6 in which the gates are slot valves.

8. An apparatus according to claim 7 in which the degas sub-chamber is positioned above the slot valves.

9. An apparatus according to any previous claim in which the semiconductor substrate handling devices and the plurality of process chambers are disposed circumferentially around the main chamber.

10. An apparatus according to any previous claim in which the degas sub-chamber comprises one or more heating devices for increasing the temperature of the semiconductor substrate.

11. An apparatus according to claim 10 in which the one or more heating devices are disposed above the lifting device.

12. An apparatus according to claim 10 or claim 11 in which the one or more heating devices comprise at least one device for emitting electromagnetic radiation, optionally at least one IR emitting device.

13. A transport module for transporting a semiconductor substrate under vacuum conditions comprising:
a vacuum chamber comprising a main chamber and a degas sub-chamber;
a first pumping system in connection with the main chamber for maintaining a vacuum within the main chamber;
a second pumping system in connection with the degas sub-chamber for maintaining a vacuum within the degas sub-chamber;
at least one transport device for transporting a semiconductor substrate between desired locations;
a substrate support; and
a lifting device for moving the substrate support between a raised position and a lowered position; the lifting device being configured so that the lowered position allows the transport device to position a semiconductor substrate on the substrate support and the raised position causes (i) a substrate disposed on the substrate support to be positioned within the degas sub-chamber and (ii) the degas sub-chamber to be sealed from the main chamber so that a vacuum is maintained in the degas sub-chamber by the second pumping system.

14. A degas apparatus for retro-fitting to an existing transport module to provide a transport module according to claim 13, the degas apparatus comprising:
a degas sub-chamber;
a pumping system in connection with the degas sub-chamber for maintaining a vacuum within the degas sub-chamber;
an auxiliary sub-chamber having an opening, the degas sub-chamber being disposed above the auxiliary sub-chamber;a substrate support; and
a lifting device for moving the substrate support between a raised position and a lowered position; the lifting device being configured so that the lowered position allows the a semiconductor substrate to be introduced to the auxiliary sub-chamber through the opening and positioned on the substrate support and the raised position causes (i) a semiconductor substrate disposed on the substrate support to be positioned within the degas sub-chamber and (ii) the degas sub-chamber to be sealed from the main chamber so that a vacuum is maintained in the degas sub-chamber by the pumping system.

15. A method of processing a semiconductor substrate comprising the steps of:
providing an apparatus comprising: one or more semiconductor substrate handling devices through which a semiconductor substrate can be introduced to and/or removed from the apparatus; a plurality of process chambers for processing the semiconductor substrate; and a transport module for transporting the semiconductor substrate under vacuum conditions between the semiconductor substrate handling devices and the plurality of process chambers; in which the transport module comprises: a vacuum chamber comprising a main chamber and a degas sub-chamber; a first pumping system in connection with the main chamber to maintain a vacuum within the main chamber; a second pumping system in connection with the degas sub-chamber to maintain a vacuum within the degas sub-chamber; at least one transport device for transporting the semiconductor substrate between desired locations which include the semiconductor substrate handling devices and the plurality of process chambers; a substrate support; and a lifting device for moving the substrate support between a raised position and a lowered position;
introducing a semiconductor substrate to the main chamber of the transport module using the transport device;
using the transport device to position the semiconductor substrate on the substrate support in its lowered position;
raising the substrate support to its raised position to cause (i) the semiconductor substrate to be positioned within the degas sub-chamber and (ii) the degas sub-chamber to be sealed from the main chamber so that a vacuum is maintained in the degas sub-chamber by the second pumping system;
degassing the semiconductor substrate in the degas sub-chamber;
lowering the substrate support to its lowered position and using the transport device to position the semiconductor substrate in one of the process chambers;
processing the semiconductor substrate in one or more of the process chambers; and
transporting the semiconductor substrate to a semiconductor substrate handling device.
